# EUROPEAN PATENT APPLICATION

(11) **EP 4 779 341 A1**
(43) Date of publication of application: **22.07.2026**
(21) Application number: 25855286.8
(22) Date of filing: 01.07.2025
(51) Int. Cl.: G01R 31/396, G01R 31/367, G01R 31/36, G01R 31/385, H01M 10/42, B60L 58/18

(54) **SYSTEM AND METHOD FOR MANAGING BATTERIES**

(30) Priority: 11.10.2024 KR 20240138160
(71) Applicant: LG ENERGY SOLUTION, LTD., Seoul 07335 (KR)
(72) Inventor: LEE, Bokyun, Yuseong-ku, Daejeon 34122 (KR)
(74) Representative: Plasseraud IP
(86) International application number: PCT/KR2025/009280
(87) International publication number: WO 2026/079583

(57) **Abstract**

A system and method for managing battery reduce manufacturing costs by performing assignment of unique identification information to each of a plurality of batteries through a single hard-wired line even when the capacity of a battery required in a vehicle increases.

## Description

### [Technical Field]

The present disclosure relates to a system and method for managing battery.

### [Background Art]

Currently commercialized secondary batteries include nickel cadmium batteries, nickel hydrogen batteries, nickel zinc batteries, lithium secondary batteries, etc. Among these, lithium secondary batteries are in the spotlight because they have almost no memory effect compared to nickel-based secondary batteries, and thus are free to charge and discharge and have a very low self-discharge rate and high energy density.

Recently, secondary batteries (batteries) are widely used for driving or energy storage in vehicles such as electric two-wheelers and electric cars, and medium and large devices such as an energy storage system (ESS). As a result, interest in batteries is increasing, and research and development related to batteries are being conducted more actively. Furthermore, in the case of batteries used in vehicles, commercialization and research on exchangeable common battery packs are also actively being conducted.

Lithium secondary batteries mainly use lithium oxides and carbon materials as positive and negative active materials. In addition, a lithium secondary battery includes an electrode assembly in which positive and negative electrode plates on which positive and negative active materials are respectively applied are arranged with a separator interposed therebetween, and an outer case (i.e., a battery case) that seals and houses the electrode assembly with an electrolyte. Depending on the shape of the outer case, the lithium secondary battery may be classified into a can-type secondary battery in which the electrode assembly is built into a metal can and a pouch-type secondary battery in which the electrode assembly is built into a pouch of an aluminum laminate sheet. Further, the can-type secondary battery may be further classified into a rectangular secondary battery and a cylindrical secondary battery depending on the shape thereof.

Secondary batteries may constitute a battery module or a battery pack in such a manner that multiple batteries are electrically connected to each other and stored together in a module case (module housing) or a pack case (pack housing). Here, each secondary battery included in the battery module or battery pack may be referred to as a battery cell.

In a battery system in which a plurality of batteries in the form of battery cells, battery modules, or battery packs is configured in parallel, a battery management system (BMS) located within the battery can operate and manage the battery system by assigning an ID for each battery location. A method of assigning a battery ID is a method of utilizing a voltage difference through a hard-wired line. However, as the capacity of the battery required for vehicles such as commercial vehicles increases, there is a problem in that the number of hard-wired lines also increases to increase the manufacturing cost.

### [Disclosure]

### [Technical Problem]

According to an embodiment of the present disclosure, a system and method for managing battery for assigning unique identification information to each of a plurality of batteries through a single hard-wired line can be provided.

The aspects to be achieved in the present disclosure are not limited to the aspect mentioned above, and can be expanded in various manners within a scope that does not deviate from the spirit and scope of the present disclosure.

### [Technical Solution]

A system for managing battery according to an embodiment of the present disclosure includes a plurality of slave battery management devices corresponding to a plurality of batteries, and a master battery management device configured to transmit/receive data to/from the plurality of slave battery management devices and perform assignment of unique identification information to each of the plurality of batteries, wherein the master battery management device and the plurality of batteries are connected via a single hard-wired line.

The single hard-wired line may include a hard-wired line connected between the master battery management device and two slave battery management devices adjacent to the master battery management device, and a hard-wired line connected between two slave battery management devices adjacent to each other.

The master battery management device may assign unique identification information to each of the plurality of batteries by repeatedly performing a process of changing a signal of the hard-wired line connected between the master battery management device and a slave battery management device or between two adjacent slave battery management devices to a HIGH state.

The master battery management device may transmit an assignment start command to each of the plurality of slave battery management devices in order to change all signals of the hard-wired lines to a LOW state before performing the operation of assigning the unique identification information to each of the batteries.

The slave battery management devices may change signals of the hard-wired lines connected to the slave battery management devices to a LOW state based on the assignment start command received from the master battery management device.

The master battery management device may assign the unique identification information to each of the plurality of batteries by repeatedly performing a process of transmitting a designation command to one of the slave battery management devices on the plurality of slave battery management devices.

The slave battery management devices may designate unique identification information of batteries corresponding to the slave battery management devices based on the designation command received from the master battery management device, respond to the master battery management device with the designated unique identification information, and change the signals of the hard-wired lines connected to the slave battery management devices to a HIGH state.

The master battery management device may transmit/receive data to/from the slave battery management devices through controller area network (CAN) communication.

Each of the batteries may represent one of a battery cell, a battery cell group, a battery module, a battery pack, and a battery rack.

A method for managing battery according to an embodiment of the present disclosure is a method for managing battery performed by a system for managing battery including a plurality of slave battery management devices corresponding to a plurality of batteries, and a master battery management device configured to transmit/receive data to/from the plurality of slave battery management devices, the method including assigning unique identification information to each of the batteries by the master battery management device, wherein the master battery management device and the plurality of batteries are connected via a single hard-wired line.

The single hard-wired line may include a hard-wired line connected between the master battery management device and two slave battery management devices adjacent to the master battery management device, and a hard-wired line connected between two slave battery management devices adjacent to each other.

The assigning unique identification information may include assigning the unique identification information to each of the plurality of batteries by repeatedly performing a process of changing a signal of the hard-wired line connected between the master battery management device and a slave battery management device or between two adjacent slave battery management devices to a HIGH state.

The assigning unique identification information may include transmitting an assignment start command to each of the plurality of slave battery management devices in order to change all signals of the hard-wired lines to a LOW state.

The assigning unique identification information may further include assigning the unique identification information to each of the plurality of batteries by repeatedly performing a process of transmitting a designation command to one of the slave battery management devices on the plurality of slave battery management devices after the transmitting the assignment start command.

A computer-readable storage medium according to an embodiment of the present disclosure records a program causing a computer to execute the method for managing battery.

### [Advantageous Effects]

According to an embodiment of the present disclosure, even if the capacity of a battery required in a vehicle increases, unique identification information can be assigned to each of a plurality of batteries through a single hard-wired line, thereby reducing the manufacturing cost.

The effects according to the various embodiments of the present disclosure are not limited to the effects described above, and it is obvious to a person skilled in the art that various effects are inherent in the present disclosure.

### [Description of Drawings]

FIG. 1 is a block diagram illustrating a battery management device according to an embodiment of the present disclosure.
FIG. 2 is a diagram illustrating a system for managing battery according to an embodiment of the present disclosure.
FIG. 3 is a flowchart illustrating a method for managing battery according to an embodiment of the present disclosure.
FIG. 4 is a flowchart illustrating a unique identification information assignment step illustrated in FIG. 3.
FIG. 5 is a diagram illustrating an example of a unique identification information assignment operation according to an embodiment of the present disclosure and showing an operation of transmitting a unique identification information assignment start command.
FIG. 6 is a diagram illustrating an example of the unique identification information assignment operation according to an embodiment of the present disclosure and showing an operation of transmitting a unique identification information designation command to a first slave battery management device.
FIG. 7 is a diagram illustrating an example of the unique identification information assignment operation according to an embodiment of the present disclosure and showing an operation of receiving a response to unique identification information from the first slave battery management device.
FIG. 8 is a diagram illustrating an example of the unique identification information assignment operation according to an embodiment of the present disclosure and showing an operation of transmitting a unique identification information designation command to a second slave battery management device.
FIG. 9 is a diagram illustrating an example of the unique identification information assignment operation according to an embodiment of the present disclosure and showing an operation of receiving a response to unique identification information from the second slave battery management device.
FIG. 10 is a diagram illustrating an example of the unique identification information assignment operation according to an embodiment of the present disclosure and showing an operation of transmitting a unique identification information designation command to a third slave battery management device.
FIG. 11 is a diagram illustrating an example of the unique identification information assignment operation according to an embodiment of the present disclosure and showing an operation of receiving a response to unique identification information from the third slave battery management device.

### [Mode for Disclosure]

Hereinafter, embodiments of the present disclosure will be described in detail with reference to the attached drawings. The advantages and features of the embodiments of the present disclosure, and methods for achieving the same will become clear with reference to the contents described in detail below together with the attached drawings. However, the embodiments of the present disclosure are not limited to the embodiments described below, but may be implemented in various different forms, and the embodiments of the present disclosure are defined only by the scope of the claims.

Like reference numerals refer to like elements throughout the specification. Unless otherwise defined, all terms (including technical and scientific terms) used in the specification may be used in meanings that can be commonly understood by a person having ordinary knowledge in the technical field to which the embodiments of the present disclosure belong. In addition, terms defined in a commonly used dictionary shall not be ideally or excessively interpreted unless explicitly specifically defined.

In the present disclosure, the terms "first", "second", etc. are used to distinguish a particular component from other components, and the components described above are not limited by these terms. For example, the "first" component may be used to refer to an element of the same or similar form as the "second" component.

In this specification, identification symbols (e.g., a, b, c, etc.) for each step are used for convenience of explanation, and the identification symbols do not describe the order of steps, and the steps may occur in a different order than the stated order unless the context clearly indicates a specific order. That is, the steps may occur in the same order as the stated order, may be performed substantially simultaneously, or may be performed in the opposite order.

In the present disclosure, the terms "comprise", "comprising", and the like may indicate the presence of features (for example, numerical values, functions, operations, or components such as parts), but such terms do not exclude additional features.

Further, the term "~ part" described in this specification means a software or hardware component such as a field-programmable gate array (FPGA) or an ASIC, and the "~ part" performs certain roles. However, the "~ part" is not limited to software or hardware. The "~ part" may be configured to be in an addressable storage medium and may be configured to operate one or more processors. Accordingly, as an example, the "~ part" includes components such as software components, object-oriented software components, class components, and task components, processes, functions, properties, procedures, subroutines, segments of program code, drivers, firmware, microcode, circuits, data structures, and variables. Functions provided in the components and "~ parts" may be combined into a smaller number of components and "~ parts" or further separated into additional components and "~ parts".

Hereinafter, a system and method for managing battery according to an embodiment of the present disclosure will be described in detail with reference to the attached drawings.

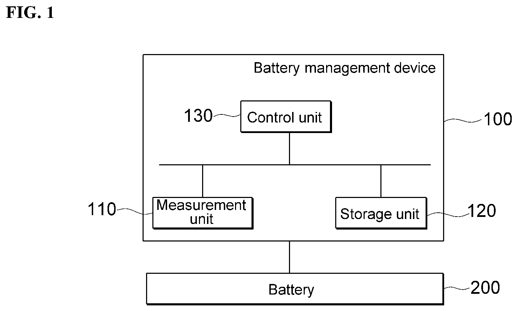

First, a battery management device according to an embodiment of the present disclosure will be described with reference to FIG. 1.

FIG. 1 is a block diagram illustrating a battery management device according to an embodiment of the present disclosure.

Referring to FIG. 1, the battery management device 100 according to an embodiment of the present disclosure may perform a diagnostic operation and/or a control operation for a battery 200.

Here, the battery 200 may be a concept including a battery cell representing one secondary battery, a battery cell group including multiple battery cells, a battery module, a battery pack, a battery rack, etc.

To this end, the battery management device 100 may include a measurement unit 110, a storage unit 120, and a control unit 130.

The measurement unit 110 may be configured to measure state information of the battery 200.

Here, the state information of the battery 200 may include the internal state and/or the external state of the battery 200. For example, the measurement unit 110 may measure information such as the voltage, current, temperature, state of charge (SoC), depth of discharge (DoD), internal resistance, state of health (SoH), idle state, overvoltage or overcurrent state, balancing state, etc. of the battery 200 as the internal state of the battery 200. For this purpose, the measurement unit 110 may be equipped with various sensors such as a voltage sensor and a current sensor. As another example, the measurement unit 110 may measure state information such as temperature, humidity, smoke, etc. around the battery 200 as the external state of the battery 200. For this purpose, the measurement unit 110 may be equipped with sensors such as a temperature sensor, a humidity sensor, and a smoke sensor. In this respect, the measurement unit 110 may also be referred to as a sensor.

The measurement unit 110 may measure the state information of the battery 200 one-dimensionally by measuring voltage, current, temperature, etc. through sensors. In addition, the measurement unit 110 may perform two-dimensional processing such as calculation on the information obtained one-dimensionally. For example, the measurement unit 110 may measure the state information of the battery 200 by calculating or estimating the state of the battery 200, such as the state of charge (SoC), internal resistance, state of health (SoH), and imbalancing based on state information such as voltage, current, and temperature.

In addition, the measurement unit 110 may transmit the measured state information of the battery 200 to the control unit 130.

The storage unit 120 may be configured to store computer-executable instructions or program code, program data, and/or other suitable forms of information for each component of the battery management device 100, i.e., the measurement unit 110 and/or the control unit 130, to perform their functions. A program stored in the storage unit 120 may include a set of instructions executable by the control unit 130. In an embodiment of the present disclosure, the storage unit 120 may be a memory (a volatile memory such as a random access memory, a nonvolatile memory, or a suitable combination thereof), one or more magnetic disc storage devices, optical disc storage devices, flash memory devices, other forms of storage media that can be accessed by the battery management device 100 and store desired information, or a suitable combination thereof.

In this case, the storage unit 120 may be implemented in a form integrated into another component included in the battery management device 100, such as a component serving as the control unit 130. For example, the storage unit 120 may be implemented in the form of an embedded memory mounted in a processor serving as the control unit 130.

The control unit 130 may receive measured state information from the measurement unit 110. Then, the control unit 130 may perform a diagnostic operation and/or a control operation for the battery 200 using the state information received from the measurement unit 110.

The control unit 130 may transmit information according to the diagnostic operation and/or the control operation for the battery 200 to another component or store the information. Here, the other component may be a component included inside the battery management device 100 according to an embodiment of the present disclosure or a component included in another device existing outside the battery management device 100. In particular, when the target battery 200 is mounted on a vehicle, the battery management device 100 may transmit information according to the diagnostic operation and/or the control operation for the battery 200 to a vehicle-side upper control system, such as a vehicle control unit (VCU), an electronic control unit (ECU), etc.

Further, the control unit 130 may transmit the information according to the diagnostic operation and/or the control operation for the battery 200 using various wired and wireless communication configurations or methods. For example, the control unit 130 may transmit the information according to the diagnostic operation and/or control operation for the battery 200 to a vehicle-side control system using controller area network (CAN) communication.

In addition, the control unit 130 may be configured to control the charging operation or the discharging operation of the battery 200 as one of control operations for the battery 200. At this time, the control unit 130 may directly perform charging control or discharging control for the battery 200. The control unit 130 may also indirectly instruct or control other components provided inside or outside the battery management device 100 to perform charging control or discharging control.

In addition, the control unit 130 may perform a processing operation for each state of the battery 200. In this case, the control unit 130 may be configured to perform different processing operations for respective states. In addition, the control unit 130 may perform at least partially identical processing operations for different states. Further, the processing operations performed by the control unit 130 do not necessarily include only active operations, and may also include passive operations. In particular, the processing operations performed by the control unit 130 may include operations that do not perform any control or communication.

In addition, when the control unit 130 directly performs a processing operation for the battery 200, the control unit 130 may transmit results of performed processing to other components.

In addition, a battery management operation according to an embodiment of the present disclosure may be applied not only to a single battery cell, but also to a unit including a plurality of battery cells, such as a cell assembly, a battery module, a battery pack, a battery rack, or an energy storage system (ESS).

In addition, the control unit 130 may perform related operations or functions by selectively including a processor, a controller, an application-specific integrated circuit (ASIC), other chipsets, a logic circuit, a register, a communication modem, a data processing device, etc. known in the art at least partially. In addition, these operations may be implemented as software, and in this case, the program may be stored in the storage unit 120. In this respect, the term "control unit" may be replaced with terms such as a processor, a controller, and a chipset. In addition, at least some of the functions of the measurement unit 110 may also be implemented as these components.

In addition, the control unit 130 does not necessarily have to be physically integrated or located at the same location. For example, some of the functions of the control unit 130 may be performed on the side of the battery 200, and other functions of the control unit 130 may be performed on the vehicle side.

More specifically, at least a part of the control unit 130 may be implemented by a battery management system (BMS) generally included in a battery pack, an energy storage system (ESS), etc. In this case, at least a part of the control unit 130 may be implemented in a form included in the battery 200. Alternatively, at least a part of the control unit 130 may be located outside the battery management device 100. For example, at least some functions of the control unit 130 may be implemented by a control device mounted on the vehicle, such as a VCU or an ECU. In addition, the measurement unit 110 may also be implemented as an integrated or separate part or component.

Meanwhile, one battery management device 100 may perform integrated diagnostic operations and/or control operations for each of a plurality of batteries 200. One battery management device 100 may be provided for each battery 200. For example, when there are three batteries 200, three battery management devices 100 may be provided to perform diagnostic operations and/or control operations for the three batteries 200. At this time, one battery management device 100 among the plurality of battery management devices 100 may operate as a master, and the remaining battery management devices 100 may operate as slaves. One battery management device 100 operating as a master may control the operations of the remaining battery management devices 100 operating as slaves in order to perform integrated management of all of the plurality of batteries 200. Alternatively, all of the plurality of battery management devices 100 may operate as slaves and a separate battery management device 100 for controlling the operations of the plurality of battery management devices 100 operating as slaves may be provided.

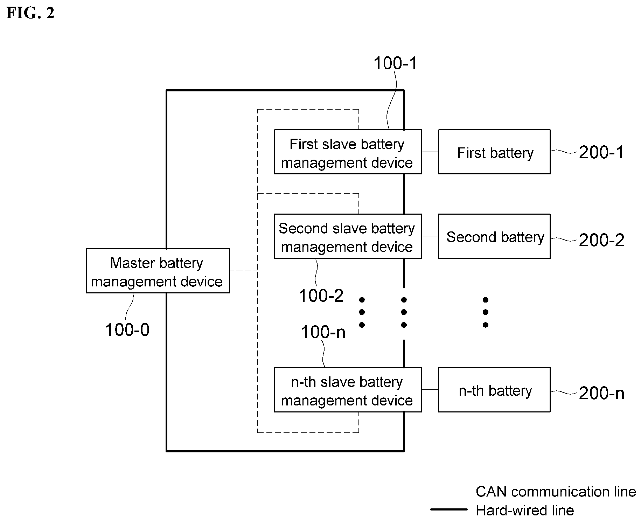

A system for managing battery according to an embodiment of the present disclosure will be described with reference to FIG. 2.

FIG. 2 is a diagram illustrating a system for managing battery according to an embodiment of the present disclosure.

Referring to FIG. 2, the system for managing battery may include a plurality of slave battery management devices 100-1 to 100-n corresponding to a plurality of batteries 200-1 to 200-n and a master battery management device 100-0 connected to the plurality of slave battery management devices 100-1 to 100-n.

Here, each of the plurality of batteries 200-1 to 200-n may represent one of a battery cell, a battery cell group, a battery module, a battery pack, and a battery rack.

The master battery management device 100-0 may transmit/receive data to/from the plurality of slave battery management devices 100-1 to 100-n and assign unique identification information to each of the plurality of batteries 200-1 to 200-n.

Here, the unique identification information refers to unique information by which the battery 200 can be identified, such as an ID, serial number, etc.

In addition, the master battery management device 100-0 and the plurality of slave battery management devices 100-1 to 100-n may be connected through a single hard-wired line.

Here, the single hard-wired line may include a hard-wired line connected between the master battery management device 100-0 and two slave battery management devices 100-1 and 100-n adjacent to the master battery management device 100-0, and a hard-wired line connected between the two slave battery management devices 100-1 and 100-n adjacent to each other. For example, the single hard-wired line may be composed of a 0-th sub-line connecting the master battery management device 100-0 and the first slave battery management device 100-1, a first sub-line connecting the first slave battery management device 100-1 and the second slave battery management device 100-2, a second sub-line connecting the second slave battery management device 100-2 and the third slave battery management device, ..., an (n-1)-th sub-line connecting the (n-1)-th slave battery management device and the n-th slave battery management device 100-n, and an n-th sub-line connecting the n-th slave battery management device 100-n and the master battery management device 100-0.

The master battery management device 100-0 may transmit/receive data to/from the plurality of slave battery management devices 100-1 to 100-n through CAN communication.

Accordingly, the system for managing battery according to an embodiment of the present disclosure can assign unique identification information to each of multiple batteries 200 through a single hard-wired line even if the capacity of the battery required in the vehicle increases, thereby reducing the manufacturing cost.

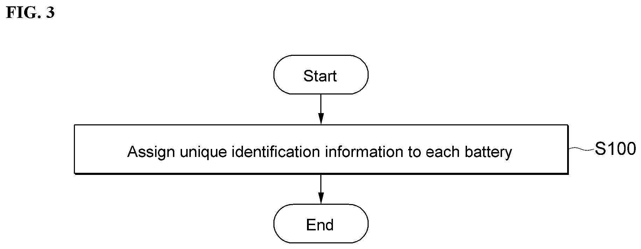

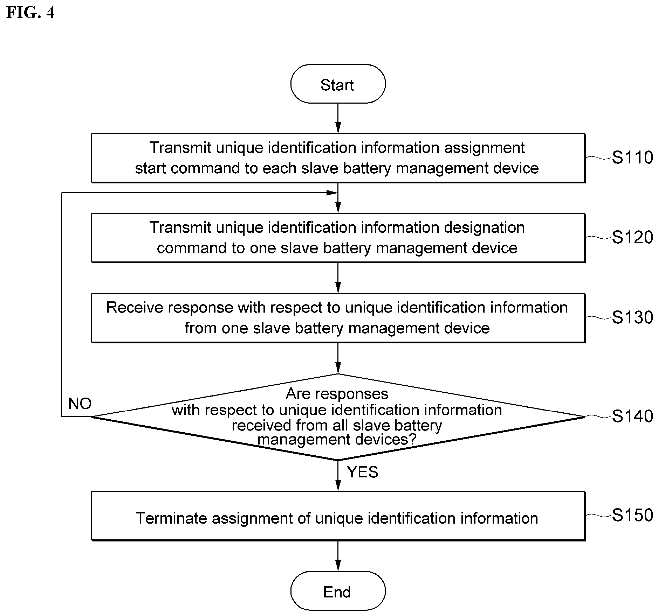

An operation of assigning unique identification information to each of multiple batteries 200-1 to 200-n in a method for managing battery according to an embodiment of the present disclosure will be described in more detail with reference to FIG. 3 and FIG. 4.

FIG. 3 is a flowchart illustrating the method for managing battery according to an embodiment of the present disclosure, and FIG. 4 is a flowchart illustrating a unique identification information allocation step illustrated in FIG. 3.

Referring to FIG. 3, the master battery management device 100-0 may assign unique identification information to each of the plurality of batteries 200-1 to 200-n (S100).

That is, the master battery management device 100-0 may assign unique identification information to each of the plurality of batteries 200-1 to 200-n by repeatedly performing a process of changing a signal of the hard-wired line connected between the master battery management device 100-0 and the slave battery management devices 100-1 and 100-n or between two adjacent slave battery management devices 100-1 to 100-n to a HIGH state.

More specifically, referring to FIG. 4, the master battery management device 100-0 may transmit a unique identification information assignment start command to each of the plurality of slave battery management devices 100-1 to 100-n to change all signals of the hard-wired lines to a LOW state (S110). Upon reception of the assignment start command from the master battery management device 100-0, the slave battery management devices 100-1 to 100-n may change the signal of the hard-wired line connected thereto to a LOW state.

For example, the master battery management device 100-0 may transmit the unique identification information assignment start command to each of the plurality of slave battery management devices 100-1 to 100-n while changing the signal of the 0-th sub-line connecting the master battery management device 100-0 and the first slave battery management device 100-1 to a LOW state. Upon reception of the assignment start command, the first slave battery management device 100-1 may change a signal of the first sub-line connecting the first slave battery management device 100-1 and the second slave battery management device 100-2, which is a hard-wired line connected thereto, to a LOW state. Upon reception the assignment allocation start command, the second slave battery management device 100-2 may change a signal of the second sub-line connecting the second slave battery management device 100-2 and the third slave battery management device, which is a hard-wired lines connected thereto, to a LOW state. Upon reception of the assignment start command, the n-th slave battery management device 100-n may change a signal of the n-th sub-line connecting between n-th slave battery management device 100-n and the master battery management device 100-0, which is a hard-wired lines connected thereto, to a LOW state.

Then, the master battery management device 100-0 may perform an operation of assigning unique identification information to each of the plurality of batteries 200-1 to 200-n.

That is, the master battery management device 100-0 may repeatedly perform an operation of transmitting a designation command to one slave battery management device (one of 100-1 to 100-n) on the plurality of slave battery management devices 100-1 to 100-n, thereby assigning unique identification information to each of the plurality of batteries 200-1 to 200-n. Upon reception of the designation command from the master battery management device 100-0, each of the plurality of slave battery management devices 200-1 to 200-n may designate unique identification information of a battery 200 corresponding thereto, respond to the master battery management device 100-0 with the designated unique identification information, and change the signal of the hard-wired line connected thereto to a HIGH state.

In other words, the master battery management device 100-0 may transmit a unique identification information designation command to one slave battery management device (one of 100-1 to 100-n) (S120). Upon reception of the designation command, one slave battery management device (one of 100-1 to 100-n) may designate unique identification information of a battery 200 corresponding thereto, respond to the master battery management device 100-0 with the designated unique identification information, and change the signal of the hard-wired line connected thereto to a HIGH state.

Then, the master battery management device 100-0 may receive the response with respect to unique identification information from one slave battery management device (one of 100-1 to 100-n) (S130).

Thereafter, upon reception of responses with respect to unique identification information from all slave battery management devices 100-1 to 100-n (S140-Y), the master battery management device 100-0 may terminate assignment of unique identification information (S150).

On the other hand, if responses with respect to unique identification information are not received from all slave battery management devices 100-1 to 100-n (S140-N), the master battery management device 100-0 may perform the designation command transmission step S120 and the response reception step S130 for another slave battery management device one of 100-1 to 100-n).

For example, the master battery management device 100-0 may transmit a unique identification information designation command to the first slave battery management device 100-1 while changing the signal of the 0-th sub-line connecting the master battery management device 100-0 and the first slave battery management device 100-1 to a HIGH state. Upon reception of the designation command, the first slave battery management device 100-1 may designate unique identification information of the first battery 200-1, respond to the master battery management device 100-0 with the designated unique identification information, and change the signal of the first sub-line connecting the first slave battery management device 100-1 and the second slave battery management device 100-2, which is a hard-wired line connected thereto, to a HIGH state. Then, the master battery management device 100-0 may receive the response from the first slave battery management device 100-1 with respect to the unique identification information of the first battery 200-1.

Then, the master battery management device 100-0 may transmit the unique identification information designation command to the second slave battery management device 100-2. Upon reception of the designation command, the second slave battery management device 100-2 may designate unique identification information of the second battery 200-2, respond to the master battery management device 100-0 with the designated unique identification information, and change the signal of the second sub-line connecting the second slave battery management device 100-2 and the third slave battery management device, which is a hard-wired line connected thereto, to a HIGH state. Then, the master battery management device 100-0 may receive the response with respect to the unique identification information of the second battery 200-2 from the second slave battery management device 100-2.

Thereafter, the master battery management device 100-0 may transmit the unique identification information designation command to the n-th slave battery management device 100-n. Upon reception of the designation command, the n-th slave battery management device 100-n may designate unique identification information of the n-th battery 200-n, respond to the master battery management device 100-0 with the designated unique identification information, and change the signal of the n-th sub-line connecting the n-th slave battery management device 100-n and the master battery management device 100-0, which is a hard-wired line connected thereto, to a HIGH state. Then, the master battery management device 100-0 may receive the response with respect to the unique identification information of the n-th battery 200-2 from the n-th slave battery management device 100-n.

Upon reception of responses from all slave battery management devices 100-1 to 100-n, the master battery management device 100-0 may terminate assignment of unique identification information. If assignment of unique identification information is terminated normally, all signals of the hard-wired lines become a HIGH state.

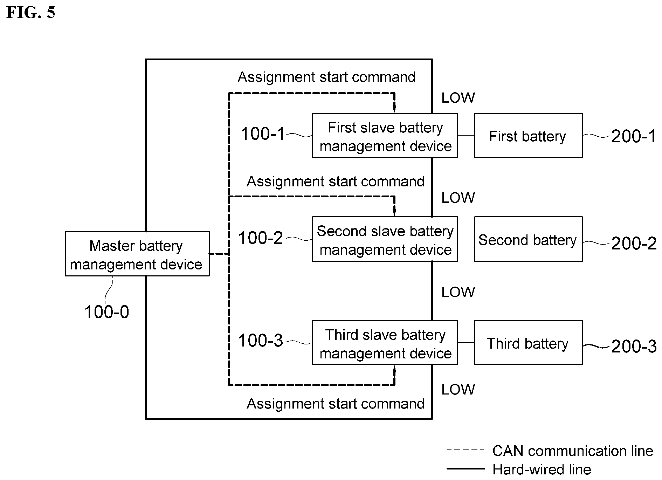

An example of a unique identification information assignment operation according to an embodiment of the present disclosure will be described with reference to FIG. 5 to FIG. 11.

A system for managing battery for describing an example of the unique identification information assignment operation according to an embodiment of the present disclosure may include three slave battery management devices 100-1 to 100-3 corresponding to three batteries 200-1 to 200-3 and the master battery management device 100-0 connected to the three slave battery management devices 100-1 to 100-3.

FIG. 5 is a diagram illustrating an example of the unique identification information assignment operation according to an embodiment of the present disclosure, and shows an operation of transmitting a unique identification information assignment start command.

Referring to FIG. 5, the master battery management device 100-0 may transmit a unique identification information assignment start command to each of the three slave battery management devices 100-1 to 100-3 while changing the signal of the 0-th sub-line connecting the master battery management device 100-0 and the first slave battery management device 100-1 to a LOW state in order to change all signals of hard-wired lines to the LOW state. Upon reception of the assignment start command, the first slave battery management device 100-1 may change the signal of the first sub-line connecting the first slave battery management device 100-1 and the second slave battery management device 100-2, which is a hard-wired line connected thereto, to the LOW state. Upon reception of the assignment start command, the second slave battery management device 100-2 may change the signal of the second sub-line connecting the second slave battery management device 100-2 and the third slave battery management device, which is a hard-wired line connected thereto, to the LOW state. Upon reception of the assignment start command, the third slave battery management device 100-3 may change the signal of the third sub-line connecting the third slave battery management device 100-3 and the master battery management device 100-0, which is a hard-wired line connected thereto, to the LOW state.

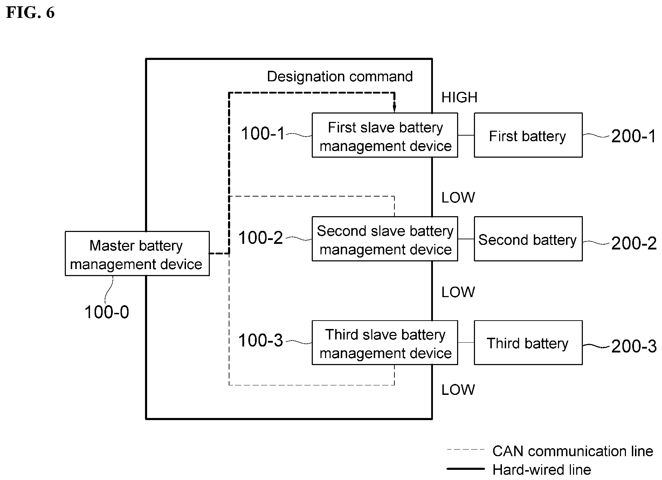

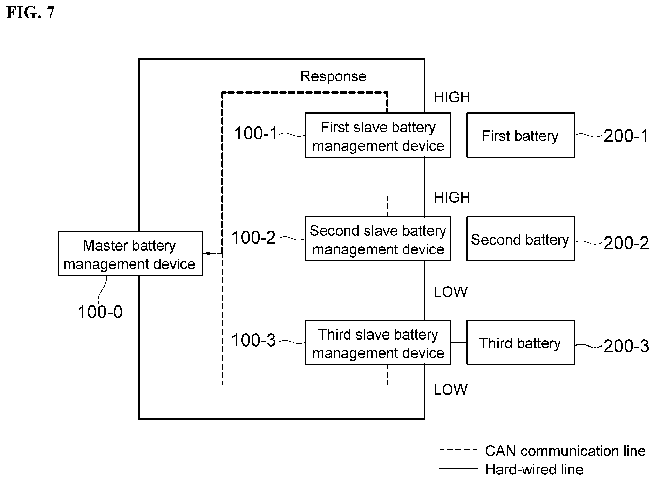

FIG. 6 is a diagram illustrating an example of the unique identification information assignment operation according to an embodiment of the present disclosure and shows an operation of transmitting a unique identification information designation command to the first slave battery management device, and FIG. 7 is a diagram illustrating an example of the unique identification information assignment operation according to an embodiment of the present disclosure and shows an operation of receiving a response with respect to unique identification information from the first slave battery management device.

Referring to FIG. 6, the master battery management device 100-0 may transmit a unique identification information designation command to the first slave battery management device 100-1 while changing the signal of the 0-th sub-line connecting the master battery management device 100-0 and the first slave battery management device 100-1 to a HIGH state.

Referring to FIG. 7, upon reception of the designation command from the master battery management device 100-0, the first slave battery management device 100-1 may designates unique identification information of the first battery 200-1, respond to the master battery management device 100-0 with the designated unique identification information (e.g., "ID = #1"), and change the signal of the first sub-line connecting the first slave battery management device 100-1 and the second slave battery management device 100-2, which is the hard-wired line connected thereto, to a HIGH state. Then, the master battery management device 100-0 may receive the response (e.g., "ID = #1") with respect to the unique identification information of the first battery 200-1 from the first slave battery management device 100-1.

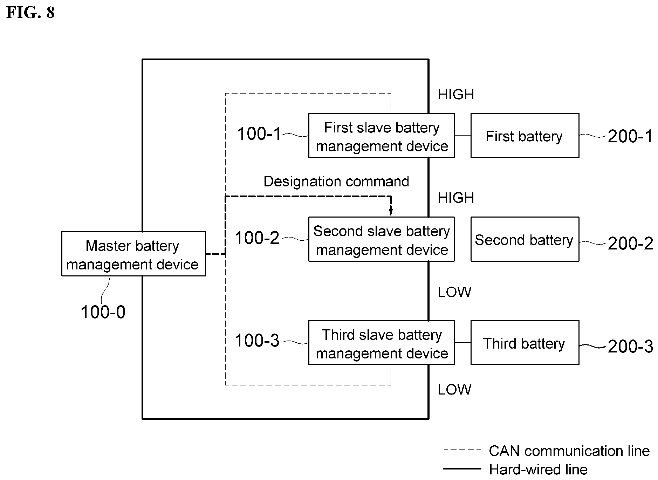

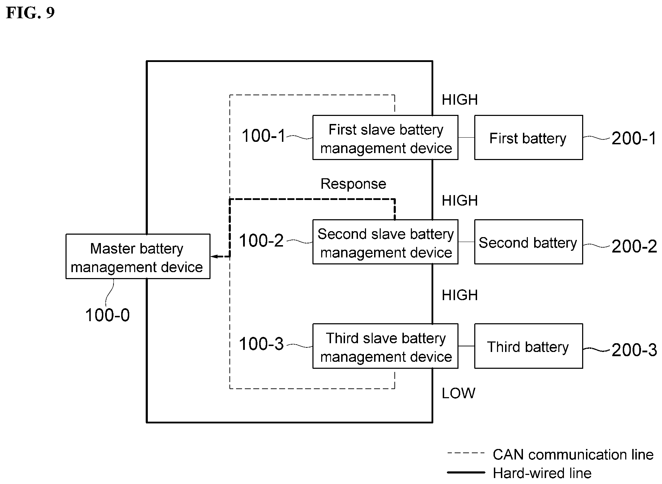

FIG. 8 is a diagram illustrating an example of the unique identification information assignment operation according to an embodiment of the present disclosure and shows an operation of transmitting a unique identification information designation command to the second slave battery management device, and FIG. 9 is a diagram illustrating an example of the unique identification information assignment operation according to an embodiment of the present disclosure and shows an operation of receiving a response with respect to unique identification information from the second slave battery management device.

Referring to FIG. 8, a master battery management device 100-0 may transmit a unique identification information designation command to the second slave battery management device 100-2.

Referring to FIG. 9, upon reception of the designation command from the master battery management device 100-0, the second slave battery management device 100-2 designates unique identification information of the second battery 200-2, responds to the master battery management device 100-0 with the designated unique identification information (e.g., "ID = #2"), and changes the signal of the second sub-line connecting the second slave battery management device 100-2 and the third slave battery management device 100-3, which is a hard-wired line connected thereto, to a HIGH state. Then, the master battery management device 100-0 may receive the response (e.g., "ID = #2") with respect to the unique identification information of the second battery 200-2 from the second slave battery management device 100-2.

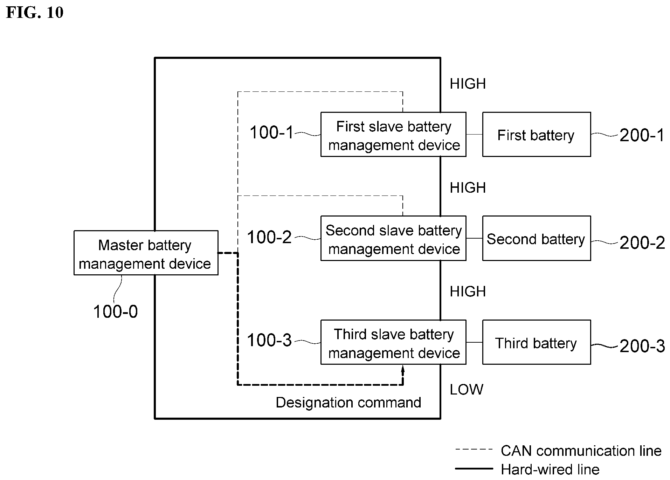

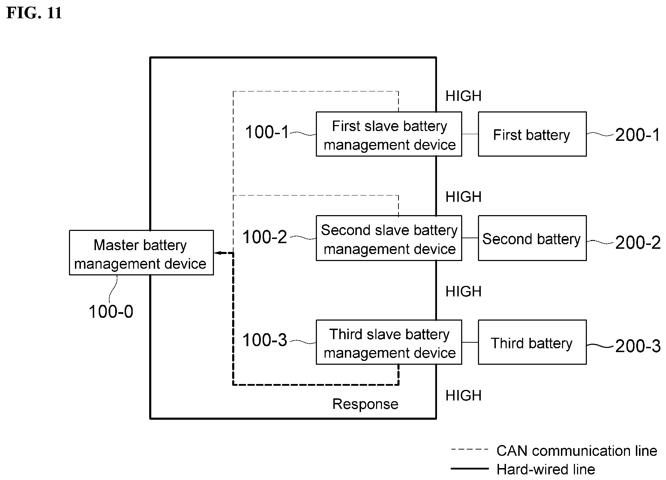

FIG. 10 is a diagram illustrating an example of the unique identification information assignment operation according to an embodiment of the present disclosure and shows an operation of transmitting a unique identification information designation command to the third slave battery management device, and FIG. 11 is a diagram illustrating an example of the unique identification information assignment operation according to an embodiment of the present disclosure and shows an operation of receiving a response with respect to unique identification information from the third slave battery management device.

Referring to FIG. 10, the master battery management device 100-0 may transmit the unique identification information designation command to the third slave battery management device 100-3.

Referring to FIG. 11, upon reception of the designation command from the master battery management device 100-0, the third slave battery management device 100-3 designates unique identification information of the third battery 200-3, responds to the master battery management device 100-0 with the designated unique identification information (e.g., "ID = #3"), and changes the signal of the third sub-line connecting the third slave battery management device 100-3 and the master battery management device 100-0, which is a hard-wired line connected thereto, to a HIGH state. Then, the master battery management device 100-0 may receive the response (e.g., "ID = #3") with respect to the unique identification information of the third battery 200-3 from the third slave battery management device 100-3.

Thereafter, the master battery management device 100-0 that has received the responses from all the three slave battery management devices 100-1 to 100-3 may terminate assignment of unique identification information. If assignment of unique identification information is normally terminated, all signals of the hard-wired lines become a HIGH state.

The operations according to the embodiments of the present disclosure described above can be implemented in the form of program instructions that can be performed through various computer means and recorded on a computer-readable storage medium. The computer-readable storage medium refers to any medium that participates in providing instructions to a processor for execution. The computer-readable storage medium may include program instructions, data files, data structures, or a combination thereof. For example, the computer-readable storage medium may include a magnetic medium, an optical storage medium, a memory, etc. The computer program may be distributed on computer systems connected through a network, and computer-readable code may be stored and executed in a distributed manner. Functional programs, code, and code segments for implementing the embodiments of the present disclosure may be easily inferred by programmers in the technical field to which the embodiments of the present disclosure belong.

The embodiments of the present disclosure are intended to explain the technical idea, and the scope of the technical idea of the embodiments of the present disclosure is not limited by these embodiments. The protection scope of the embodiments of the present disclosure should be interpreted by the following claims, and all technical ideas within the equivalent scope should be interpreted as being included in the scope of the rights of the embodiments of the present disclosure.

### <Detailed Description of Main Elements>

100: Battery management device
100-0: Master battery management device
100-1: First slave battery management device
100-2: Second slave battery management device
100-n: n-th slave battery management device
110: Measurement unit
120: Storage unit
130: Control unit
200: Battery
200-1: First battery
200-2: Second battery
200-n: n-th battery

## Claims

1. A system for managing battery comprising:
a plurality of slave battery management devices corresponding to a plurality of batteries; and
a master battery management device configured to transmit/receive data to/from the plurality of slave battery management devices and perform assignment of unique identification information to each of the plurality of batteries,
wherein the master battery management device and the plurality of batteries are connected via a single hard-wired line.

2. The system of claim 1, wherein the single hard-wired line includes a hard-wired line connected between the master battery management device and two slave battery management devices adjacent to the master battery management device, and a hard-wired line connected between two slave battery management devices adjacent to each other.

3. The system of claim 2, wherein the master battery management device assigns unique identification information to each of the plurality of batteries by repeatedly performing a process of changing a signal of the hard-wired line connected between the master battery management device and a slave battery management device or between two adjacent slave battery management devices to a HIGH state.

4. The system of claim 3, wherein the master battery management device transmits an assignment start command to each of the plurality of slave battery management devices in order to change all signals of the hard-wired lines to a LOW state before performing the operation of assigning the unique identification information to each of the batteries.

5. The system of claim 4, wherein the slave battery management devices change signals of the hard-wired lines connected to the slave battery management devices to a LOW state based on the assignment start command received from the master battery management device.

6. The system of claim 4, wherein the master battery management device assigns the unique identification information to each of the plurality of batteries by repeatedly performing a process of transmitting a designation command to one of the slave battery management devices on the plurality of slave battery management devices.

7. The system of claim 6, wherein the slave battery management devices designate unique identification information of batteries corresponding to the slave battery management devices based on the designation command received from the master battery management device, respond to the master battery management device with the designated unique identification information, and change the signals of the hard-wired lines connected to the slave battery management devices to a HIGH state.

8. The system of claim 1, wherein the master battery management device transmits/receives data to/from the slave battery management devices through controller area network (CAN) communication.

9. The system of claim 1, wherein each of the batteries represents one of a battery cell, a battery cell group, a battery module, a battery pack, and a battery rack.

10. A method for managing battery performed by a system for managing battery including a plurality of slave battery management devices corresponding to a plurality of batteries, and a master battery management device configured to transmit/receive data to/from the plurality of slave battery management devices, the method comprising assigning unique identification information to each of the batteries by the master battery management device,
wherein the master battery management device and the plurality of batteries are connected via a single hard-wired line.

11. The method of claim 10, wherein the single hard-wired line includes a hard-wired line connected between the master battery management device and two slave battery management devices adjacent to the master battery management device, and a hard-wired line connected between two slave battery management devices adjacent to each other.

12. The method of claim 11, wherein the assigning unique identification information comprises assigning the unique identification information to each of the plurality of batteries by repeatedly performing a process of changing a signal of the hard-wired line connected between the master battery management device and a slave battery management device or between two adjacent slave battery management devices to a HIGH state.

13. The method of claim 12, wherein the assigning unique identification information comprises transmitting an assignment start command to each of the plurality of slave battery management devices in order to change all signals of the hard-wired lines to a LOW state.

14. The method of claim 13, wherein the assigning unique identification information further comprises assigning the unique identification information to each of the plurality of batteries by repeatedly performing a process of transmitting a designation command to one of the slave battery management devices on the plurality of slave battery management devices after the transmitting the assignment start command.

15. A computer-readable storage medium recording a program causing a computer to execute the method for managing battery of any one of claims 10 to 14.
